# EUROPEAN PATENT APPLICATION

(11) **EP 1 772 898 A1**
(43) Date of publication of application: **11.04.2007**
(21) Application number: 05447225.3
(22) Date of filing: 06.10.2005
(51) Int. Cl.: H01L 21/336

(54) **Method for forming a silicide gate**

(71) Applicant: INTERUNIVERSITAIR MICROELEKTRONICA CENTRUM ( IMEC), 3001 Leuven (BE); TEXAS INSTRUMENTS INC., Dallas, Texas 75265 (US)
(72) Inventor: Absil, Philippe, 1471 Loupoigne (BE); Kittl, Jorge, 1410 Waterloo (BE)
(74) Representative: Van Malderen, Joëlle

(57) **Abstract**

The present invention is related to a method for forming an at least partially silicided gate, comprising the steps of
- depositing a hardmask over a gate,
- providing a sacrificial material coating on top of said hardmask,
- etching back said sacrificial material coating until the top of said hardmask is exposed,
- etching to expose said gate,
- removing said sacrificial material,
- performing a silicidation of said gate.

## Description

### Field of the invention

The present invention relates to the field of semiconductor process technology and devices. In particular, the present invention relates to semiconductor devices with contacts formed by a reaction between a metal and a semiconductor material.

### State of the art

In general, silicidation can be defined as an anneal process resulting in the formation of a metal-semiconductor metal alloy (a silicide) to act as a contact in any semiconductor device, i.e. as a connection between two conductors that permits a flow of current. The process can be applied for any contact located higher than the substrate surface. An example can be a layer stack of some semiconductor material.

A more specific example is found in CMOS (Complementary Metal-Oxide-Silicon) technology. CMOS devices comprise two types of transistors, nMOS and pMOS, each transistor type having its own characteristics and properties. There is a trend to replace the semiconductor gate contact with a metal one, as metal gates offer the advantages of reducing the sheet resistance, eliminating the semiconductor gate depletion effect, and controlling the work function independently from the doping of the junction regions. Metal gate contacts are therefore considered as a potential candidate for future CMOS technology nodes.

Metal gate contacts can be formed by a silicidation of the semiconductor gate contact with a metal. The semiconductor gate contact may be a poly-silicon gate contact. The metal may be a refractory metal such as W, noble metals such as Pt, near noble metals such as Ni, transition metals such as Ti, or any combination thereof. The full silicidation of the poly-Si gate is obtained by a thermally enhanced reaction between a deposited metal and the already patterned silicon gate similarly to the process used to form self-aligned contacts in the source and drain (S/D) regions of a planar MOS transistor. During the silicidation process, the gate contact is converted into a gate silicide.

There are two main approaches to realise the (full or partially) silicided gates. In the first approach, a simultaneous silicidation of the source/drain (S/D) regions and the poly-Si gate contact is performed trading off the needs for a thin contact in the S/D region imposed by the junctions requirements on the one hand and the silicidation of the full thickness of the poly-Si down to gate dielectric interface on the other hand. The second approach consists of decoupling the silicidation of the S/D regions and the gate by properly protecting the S/D regions during the silicide formation process (i.e. with a material that does not react with the metal). While the simultaneous approach is more economical in terms of number of process steps and minimises the thermal budget after contact formation, the decoupling approach allows the formation of a different silicide material for the gate contact and the S/D contacts and does not require silicide thickness matching between gate and S/D.

The main approach for decoupling S/D and gate contact consists in protecting the S/D by an oxide that is first deposited, then planarised by chemo-mechanical polishing (CMP) and then etched back to open the top of the poly-Si. Although this approach employs existing processing techniques, chip manufacturers preferably avoid it because of potential yield issues. Besides, this approach leaves a relative thick oxide above the S/D regions, difficult to remove without affecting the device integrity, specifically without damaging the S/D silicide underneath. With the protective oxide present, the efficiency of deposited strained layers, typically used for device performance improvement, will be significantly reduced. Another drawback of such approach is the increased risk of protective oxide removal when fully silicided gates are realised combined with elevated S/D transistors because of a process window difference for the etch back step used to open the gate top. This makes the approach partially incompatible with today's state-of-the-art transistors.

Also when considering the making of silicided contacts more in general, it is desirable to avoid the CMP step because of the above-mentioned yield issues.

### Aims of the invention

The present invention aims to provide a method for forming an at least partially silicided contact wherein a step of chemo-mechanical polishing is avoided.

### Summary of the invention

The present invention relates to a method for forming an at least partially silicided contact, comprising the steps of
- depositing a hardmask over a contact,
- providing a sacrificial material coating on top of the hardmask,
- etching back the sacrificial material coating until the top of the contact is exposed,
- opening the contact,
- removing the sacrificial material,
- performing a silicidation of the contact.

In a preferred embodiment the hardmask can be any material that is suitable to be deposited and dry-etched selectively towards the contact. More particular it can be silicon oxide, silicon nitride or silicon carbide.

Preferably the sacrificial material coating can be any self-planarising coating suitable to be spun on the hardmask and etched back afterwards. More particularly it can be BARC (bottom anti-reflective coating) or photo-resist.

Advantageously a plurality of contacts can be formed. The step of etching back the sacrificial material coating can be performed until the lowest top of the plurality of contacts is exposed.

In a specifically advantageous embodiment the contact is in CMOS technology. The hardmask is then preferably in SiO₂. The contact advantageously is a poly-Si gate contact on top of a gate dielectricum. Said gate dielectricum can be typically SiON, SiO or a high-k material. In a preferred embodiment the step of hardmask deposition can be performed after a silicidation of a source and drain contact. Alternatively a silicidation of a source and drain contact can be performed after the silicidation of said gate contact.

In another aspect the invention relates to the use of a method for forming a silicided contact, whereby the contact is in CMOS technology, for forming a MOSFET transistor comprising a fully silicided gate contact.

In yet another aspect the invention relates to the use of a method as previously described, wherein the source contact and the drain contact of the MOSFET transistor are in a first silicide material and wherein the fully silicided gate contact is in a second silicide material, different from the first silicide material.

Finally the invention also relates to a MOSFET transistor comprising a fully silicided gate contact obtained with the method as described.

### Short description of the drawings

Fig. 1 represents the hard mask deposition.

Fig. 2 represents the planarising polymer (PP) coating.

Fig. 3 represents the sacrificial etch back step to expose the contact tops.

Fig. 4 represents the contact opening.

Fig. 5 represents the sacrificial material removal.

Fig. 6 represents the silicidation metal deposition.

Fig. 7 represents the removal of the rest of the hardmask.

### Detailed description of the invention

In the solution according to the present invention an alternative to the CMP route is proposed. Doing so, any CMP step is avoided and a significant reduction of the protective oxide thickness can be achieved.

The solution according to the invention makes use of a sacrificial protective layer during the contact opening process that can be removed prior to the contact silicidation without damaging the underlying layers.

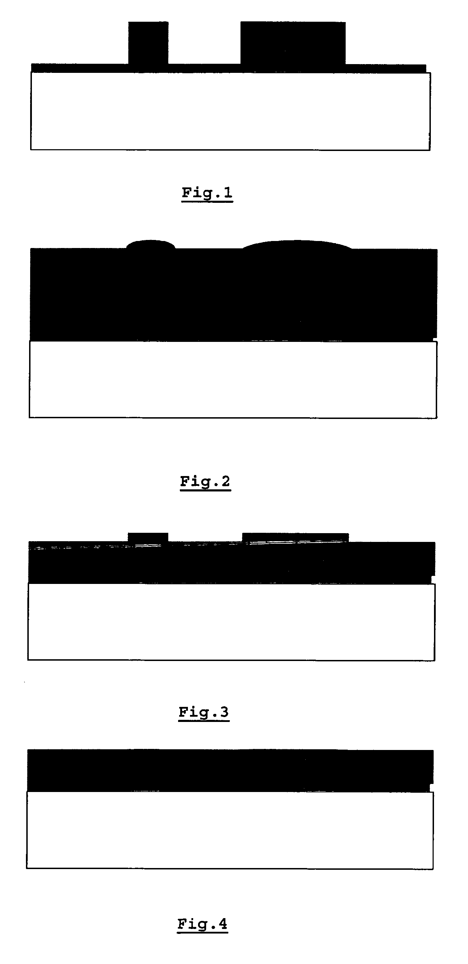

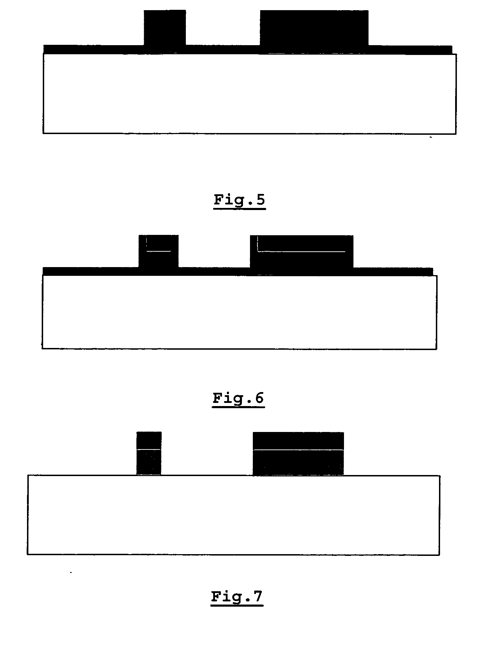

The process sequence is as follows: (i) a thin hardmask material, suitable for silicidation, is deposited over the contact (Fig.1). Any material that can be deposited and dry etched and does not react with the silicide in question is suitable for silicidation. The hardmask thickness should preferably be about a few tens of nm. Examples comprise SiO₂, SiN, SiC or amorphous carbon layer. In case CMOS technology is used, the hardmask material is advantageously SiO₂. The hardmask is then preferably deposited on the encapsulated (by gate hardmask and spacers) transistors after S/D silicidation. (ii) the devices are spun coated with a sacrificial material (ex.: BARC, photo-resist, ...) that planarises the wafer topography (Fig.2); (iii) the sacrificial material coating is etched back to expose the hardmask only on top the contacts (Fig.3); (iv) once the contact tops are exposed, a second etchback is performed to remove selectively the hardmask deposited in step (i) selectively towards the sacrificial material coating (Fig.4). In case of gate contact silicidation, also the gate hardmask is removed selectively, while the S/D regions are protected by the sacrificial material; (v) the sacrificial material coating is removed without damaging the device structure (Fig.5); (vi) the contact is now ready to be at least partially silicided following typical silicidation (Fig.6) flow starting with a metal deposition, then a partial anneal, a selective etch and a final anneal to complete the contact silicidation. After silicidation is completed, the rest of the hardmask is removed selectively towards the underlying layers and the contact (Fig.7). In a specific embodiment with CMOS technology the silicidation of the source and drain is performed after the above-mentioned steps for forming a silicidated gate contact are carried out. After the silicidation process is completed, the transistors are ready to continue processing through BEOL (back-end-of-line).

It is important to note that prior to BEOL CMOS processing, it is possible to include a hardmask removal step to etch away protective layer present in the S/D regions, provided that this layer is thin enough and can be selectively etched with respect to the silicide formed in the gate and in the S/D.

This process according to the present invention avoids any CMP step and provides a topography very similar to the one obtain for standard poly-Si gates used in today's state-of-the-art CMOS fabrication. Both aspects make FUSI gates easier to integrate.

## Claims

1. Method for forming an at least partially silicided contact, comprising the steps of
- depositing a hardmask over a contact,
- providing a sacrificial material coating on top of said hardmask,
- etching back said sacrificial material coating until the top of said contact is exposed,
- opening said contact,
- removing said sacrificial material,
- performing a silicidation of said contact.

2. Method for forming an at least partially silicided contact as in claim 1, wherein said hardmask is any material suitable to be deposited and dry-etched selectively towards said contact, more particularly silicon oxide, silicon nitride or silicon carbide.

3. Method for forming an at least partially silicided electrode as in any of claims 1 or 2, wherein said sacrificial material coating is any self-planarising coating suitable to be spun on the hardmask and etched back afterwards, more particularly bottom anti-reflective coating or photo-resist.

4. Method for forming an at least partially silicided contact as in any of the claims 1 to 3, wherein a plurality of contacts is formed.

5. Method as in claim 4, wherein said step of etching back said sacrificial material coating is performed until the lowest top of said plurality of contacts is exposed.

6. Method as in any of claims 1 to 5, wherein said contact is in CMOS technology.

7. Method as in claim 6, wherein said hardmask is in silicon oxide, silicon nitride or silicon carbide.

8. Method as in claim 6 or 7, wherein said contact is a poly-Si gate contact on top of a gate dielectricum.

9. Method as in claim 8, wherein said gate dielectricum is SiON, SiO or a high-k material.

10. Method as in claim 8, wherein the step of hardmask deposition is performed after a silicidation of a source and drain contact.

11. Method as in claim 8, wherein a silicidation of a source and drain contact is performed after the silicidation of said gate contact.

12. Use of a method as in any of claims 6 to 11 for forming a MOSFET transistor comprising a fully silicidated gate stack.

13. Use of a method as in claims 10 or 11, wherein the source contact and the drain contact of said MOSFET transistor are in a first silicide material and wherein said fully silicided gate contact is in a second silicide material, different from said first silicide material.

14. MOSFET transistor comprising a fully silicided gate stack obtained with the method as in any of claims 11 to 13.
